(19) Europäisches Patentamt
European Patent Office
Office européen des brevets

(11) **EP 4 293 901 A1**

(12) **EUROPEAN PATENT APPLICATION**

(43) Date of publication:
**20.12.2023 Bulletin 2023/51**

(21) Application number: **22305871.0**

(22) Date of filing: **14.06.2022**

(51) International Patent Classification (IPC):
**H03F 1/52** $^{(2006.01)}$    **H03F 3/187** $^{(2006.01)}$

(52) Cooperative Patent Classification (CPC):
**H03F 1/523; H03F 3/187;** H03F 2200/03;
H03F 2200/462

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **L-Acoustics
91462 Marcoussis Cedex (FR)**

(72) Inventors:
• **SCHWANN, Robert
58511 Luedenscheid (DE)**
• **WEGNER, Carsten
57074 Siegenand (DE)**

(74) Representative: **Novagraaf Technologies
Bâtiment O2
2, rue Sarah Bernhardt
CS90017
92665 Asnières-sur-Seine Cedex (FR)**

(54) **CURRENT LIMITING APPARATUS FOR DRIVING A LOUDSPEAKER**

(57)    A method for use with a sound system (called plant in control theory) (125) including a loudspeaker set (120), the method comprising: obtaining input audio samples ($r_n$) and a measured current ($m_{n-d}$) drawn by the loudspeaker set; generating, for a current time step, using a state-space model of the loudspeaker set, a state vector ($x_n$) and a model-based estimated current ($y_n$); generating, based on the state vector ($x_n$), a predicted current ($y_{e,n+1}$) for a next time step; generating, for the current time step, a limited audio sample ($u_{L,n}$) based on the state vector ($x_n$); generating a feedback signal ($f_n$) that contributes to the generation of the state vector ($x_{n+1}$) for the next time step based on the measured current ($m_{n-d}$) and a time-aligned model-based estimated current ($y_{n-d}$); generating an output audio sample ($u_n$) for the current time step, wherein the output audio sample ($u_n$) is either the input audio sample ($r_n$) for the current time step or the limited audio sample ($x_{L,n}$) when the predicted current ($y_{e,n+1}$) is higher in magnitude than a threshold ($I_{max}$).

**FIG. 1**

**Description**

TECHNICAL FIELD

Various example embodiments relate generally to a current limiting device for driving a loudspeaker and an associated method.

BACKGROUND

Most audio power amplifiers have a maximum output current limit above which the output stage could get damaged.

A common solution for linear amplifiers with a push-pull output stage is to have additional control loops that measure the output current in the emitter resistor or source resistors of that output stage of the linear amplifier and override the usual control signal to control the output devices to a constant maximum current.

In PWM amplifiers or inverters a protection circuit may be implemented in the driver IC (integrated circuit) that controls the switching output devices. The output current is detected with various methods. If the threshold of the output current is reached, the driver IC is configured to turn off the output stage completely and does a restart after a recovery time. During that time there is no output audio signal sent to the loudspeaker, which is not acceptable during normal operation of an audio amplifier.

To prevent that, additional control loops with fast current measurements may be used in the driver IC to perform a pulse-by-pulse current limiting so as to obtain a constant maximum output current.

There appears a need for an improved solution for limiting the current drawn by a loudspeaker.

SUMMARY

The scope of protection is set out by the independent claims. The embodiments, examples and features, if any, described in this specification that do not fall under the scope of the protection are to be interpreted as examples useful for understanding the various embodiments or examples that fall under the scope of protection.

According to a first aspect a device for use with a sound system (called plant in control theory) including a loudspeaker set is disclosed. The device is configured to receive input audio samples and a measured current drawn by the loudspeaker set, the device comprising: a modelling device configured to generate, for a current time step, using a state-space model of the loudspeaker set, a state vector and a model-based estimated current; a prediction device configured to generate, based on the state vector, a predicted current for a next time step; a limiting device configured to generate, for the current time step, a limited audio sample based on the state vector; a state feedback controller configured to generate a feedback signal that contributes to the generation of the state vector for the next time step and is based on the measured current and a time-aligned model-based estimated current; wherein the device is configured to generate an output audio sample for the current time step, wherein the output audio sample is either the input audio sample for the current time step or the limited audio sample when the predicted current is higher in magnitude than a threshold.

The prediction device may be configured to generate the predicted current based on one or more input audio samples.

The prediction device may be configured to generate the predicted current based on an estimated audio sample for the next time step or the input audio sample for the next time step .

The limiting device may be configured to generate the limited audio sample based on a model derived from the state-space model.

The limiting device may be configured to generate the limited audio sample based on the threshold corresponding to a maximum current.

The limited audio sample may be generated such that the magnitude of the predicted current is equal to the threshold.

The limited audio sample may be generated based on the sign of the predicted current.

The limited audio sample may be generated based on an output sample for a previous time step.

According to a second aspect a method for use with a sound system (called plant in control theory) including a loudspeaker set is disclosed. The method comprising: obtaining input audio samples and a measured current drawn by the loudspeaker set; generating, for a current time step, using a state-space model of the loudspeaker set, a state vector and a model-based estimated current; generating, based on the state vector, a predicted current for a next time step; generating, for the current time step, a limited audio sample based on the state vector; generating a feedback signal that contributes to the generation of the state vector for the next time step and is based on the measured current and a time-aligned model-based estimated current; generating an output audio sample for the current time step, wherein the output audio sample is either the input audio sample for the current time step or the limited audio sample when the predicted current is higher in magnitude than a threshold.

According to another aspect, a computer program is disclosed. The computer program comprises computer-executable instructions that, when executed by at least one processor, causes a device to perform a method according to the second aspect.

According to a third aspect a device for use with a sound system (called plant in control theory) including a loudspeaker set is disclosed. The device comprises signal processing means for performing a method comprising: obtaining input audio samples and a measured current drawn by the loudspeaker set; generating, for a current time step, using a state-space model of the loudspeaker set, a state vector and a model-based estimated current; generating, based on the state vector, a predicted current for a next time step; generating, for the current time step, a limited audio sample based on the state vector; generating a feedback signal that contributes to the generation of the state vector for the next time step and is based on the measured current and a time-aligned model-based estimated current; generating an output audio sample for the current time step, wherein the output audio sample is either the input audio sample for the current time step or the limited audio sample when the predicted current is higher in magnitude than a threshold.

The signal processing means may comprise at least one processor and at least one memory including computer program instructions, wherein the at least one memory and the computer program instructions are configured to, with the at least one processor, cause the device to perform one or more or all steps of the method. The signal processing means may comprise circuitry configured to cause the device to perform at least one or more or all steps of the method. The signal processing means may comprise a digital signal processor configured to cause the device to perform one or more or all steps of the method.

According to a fourth aspect a system including a device according to the first or third aspect is disclosed. The system comprises a database configured to store model coefficients of state-space models for several loudspeaker sets and means for loading the model coefficients corresponding to the loudspeaker set.

BRIEF DESCRIPTION OF THE DRAWINGS

Example embodiments will become more fully understood from the detailed description given herein below and the accompanying drawings, which are given by way of illustration only and thus are not limiting of this disclosure.

FIG. 1 shows a block diagram of a current limiting device according to an example.
FIG. 2A shows an example of an equivalent electrical circuit for an example loudspeaker set.
FIG. 2B shows an example of an equivalent electrical circuit for an example loudspeaker set.
FIG. 3 shows an example state-space model that may be used as loudspeaker set model.
FIG. 4 shows a closed-loop controlled model according to an example.
FIGS. 5A-5B show frequency and phase response of the admittance of a state space model, emulating a loudspeaker set including the acoustical enclosure, according to an example.
FIGS. 6A-6B shows signals illustrating the behavior of a current limiting device according to an example.
FIGS. 7A-7B shows signals illustrating the behavior of a current limiting device according to an example.

It should be noted that these drawings are intended to illustrate various aspects of devices, methods and structures used in example embodiments described herein. The use of similar or identical reference numbers in the various drawings is intended to indicate the presence of a similar or identical element or feature.

DETAILED DESCRIPTION

Various example embodiments will now be described more fully with reference to the accompanying drawings in which some example embodiments are shown. However, specific structural and/or functional details disclosed herein are merely representative for purposes of describing example embodiments. Accordingly, these embodiments are shown by way of illustrative examples in the drawings and will be described herein in detail so as to provide a thorough understanding of the various aspects. However, it will be understood by one of ordinary skill in the art that example embodiments are capable of various modifications and alternative forms and may be practiced without all the specific details. In addition, systems and processes may be shown in block diagrams so as not to obscure the example embodiments in unnecessary detail. In other instances, well-known processes, structures, and techniques may be shown without unnecessary detail in order to avoid obscuring the example embodiments.

An audio system including a current limiting device will be described in detail. The current limiting device implements a prediction algorithm that predicts the current drawn by a loudspeaker set (e.g. including one or more loudspeakers) based on a model of the loudspeaker set. A limited output voltage (limited sample values) is generated such that the magnitude of the drawn current does not exceed a specified threshold. The limited output voltage is output to the plant in replacement of the output voltage of the audio source when the magnitude of the predicted current is higher than the specified threshold.

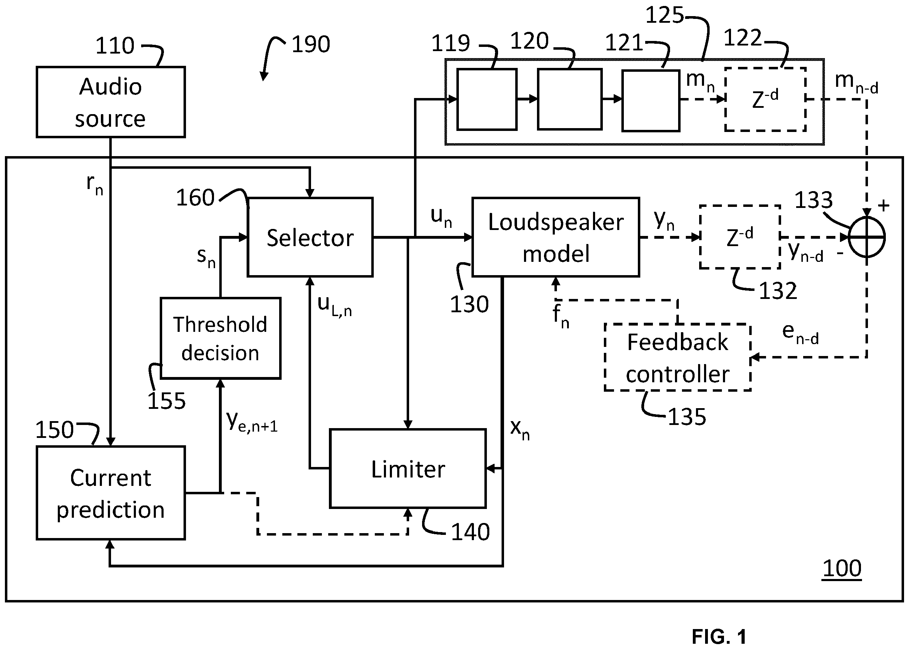

FIG. 1 shows a block diagram of a current limiting device 100 according to an example. The current limiting device 100 is connected to an audio source 110 whose output is connected via a selector 160 to a sound system 125 including a loudspeaker set 120 for playing an analog audio signal. This sound system 125 is referred to a plant in control theory.

The sound system or plant 125 includes a signal chain that may itself include: a digital to analog converter (DAC) and an amplifier stage 119, followed by a loudspeaker set 120, a current measurement device 121 generating a measured current including an analog to digital converter (ADC) delivering the measured current to the current limiting device 100. The loudspeaker set 120 may comprise one or more loudspeakers, e.g. loudspeakers of the same type connected in parallel that can be modeled using a single model. The loudspeaker set 120 may alternately comprise at least one low frequency loudspeaker and at least one high frequency loudspeaker (e.g. a woofer and a tweeter) connected by a passive cross-over network to the output of the amplifier. For a good understanding of the time alignment aspects, the schematic of FIG. 1 includes a delay element 122 that represents here the delay introduced by the digital to analog converter (DAC) and analog to digital converter (ADC).

In the example of FIG. 1, the current limiting device 100 includes means (e.g. software and / or hardware means) configured to implement: a loudspeaker set model (modelling device 130), a limiter (limiting device 140), a prediction algorithm (prediction device 150), a selector 160 and associated threshold decision function (threshold decision device 155). The current limiting device 100 may further include in a feedback loop: a delay element 132, an adder 133 and a state feedback controller 135 whose output is connected to the modelling device 130. The delayed signal $y_{n-d}$ from delay element 132 is added with a negative sign to the current measurement $m_{n-d}$.

The audio source 110 generates an audio signal that may be an analog or digital audio signal. If the audio signal is an analog audio signal, this analog audio signal is converted (e.g. by an analog to digital converter, not represented) to digital samples referred herein to as the input audio samples $r_n$, n=1 to N. If the audio signal is a digital audio signal, we assume here that it includes the input audio samples $r_n$, n=1 to N.

The current limiting device 100 receives from the audio source 110 as input signal the input audio samples $r_n$, n=1 to N and generates output audio samples $u_n$, n=1 to N that are converted (e.g. by a digital to analog converter, included in the amplifier stage represented as 119) to an analog signal to be played by the loudspeaker set 120. The input audio samples $r_n$ represent the output voltage at the output of the audio source. The output audio samples represent an output voltage which is applied inside the plant 125 to drive the loudspeaker set 120 such that the loudspeaker set 120 draws a current, referred to herein as the drawn current.

The current limiting device 100 may be implemented by signal processing circuitry configured to perform one or more or all steps and / or functions disclosed herein for the current limiting device 100. The current limiting device 100 may include or be subdivided into one or more devices and / or signal processing circuits.

The signal processing circuitry may include at least one DSP, Digital Signal Processing, circuitry. The signal processing circuitry may include at least one processor and at least one memory including computer program code, wherein the at least one memory and the computer program code are configured to, with the at least one processor, cause the apparatus to perform one or more or all steps and / or functions disclosed herein for the current limiting device 100.

In the solution described herein, a prediction algorithm is used to predict and limit the current drawn by the loudspeaker set 120 using a limited output voltage in replacement of the output signal at the output of the audio source 110, that is converted into a voltage and amplified by the amplification stage 119 and applied to the loudspeaker set 120.

The prediction algorithm is based on a loudspeaker set model implemented by the modelling device 130 connected to the output of the audio source 110 via a selector 160. The loudspeaker set model is a model of the driven loudspeaker set 120. A state-space model that corresponds to an electrical equivalent circuit of the loudspeaker set may for example be used as loudspeaker set model as will be described in detail.

The prediction device 150 is configured to implement the prediction algorithm to generate a predicted current $y_{e,n+1}$. The prediction device 150 receives as input one or more input audio samples $r_n$, n=1 to N, where the index n represents a time step index, e.g. with respect a clock signal. The prediction algorithm may use the available input audio samples (e.g. a current sample $r_n$ and a previous sample $r_{n-1}$). The prediction algorithm may use the next input audio sample if available or at least one predicted sample $r_{n+1}$ for a next time step obtained from one or more input audio samples. The predicted $r_{n+1}$ sample may for example be generated by using 2 or more input audio samples (e.g. $r_{n-1}$ and $r_n$, n=1 to N). The prediction device 150 receives as input a state vector $x_n$ from the modelling device 130 to generate at a given time step a predicted current $y_{e,n+1}$ for a next time step.

The state-space model is synchronized with the plant 125 by using a feedback error $e_{n-d}$ fed to a state feedback controller 135 of the state-space model 130. The feedback error $e_{n-d}$ is generated based on the measured current ($m_{n-d}$) and a time-aligned model-based estimated current ($y_{n-d}$). The feedback error $e_{n-d}$ may be generated as the difference between the measured current ($m_{n-d}$) and the time-aligned model-based estimated current ($y_{n-d}$). The state feedback controller 135 is configured to generate a feedback signal ($f_n$) that contributes to the generation of the state vector for next time step. This feedback signal may be a feedback vector that is added to the state vector at a current time step to generate, based on the state space model the state vector for the next time step.

The limiting device 140 is configured to implement a limiter function. The limiting device 140 receives a state vector $x_n$ from the modelling device 130 and generates a limited audio sample $u_{L,n}$, n=1 to N based on a derived model, resulting from a mathematical conversion of the loudspeaker set model. The coefficients of the derived model are based on the coefficients of the loudspeaker set model. The limited audio sample $u_{L,n}$ represents a limited audio signal different from the input audio signal (i.e. the input audio sample $r_n$) representing the audio content to be played and may be used in replacement of the corresponding input audio sample $r_n$ to avoid that the magnitude of the current drawn by the loudspeaker set 120 is above a threshold.

Also the magnitude of the current drawn by the loudspeaker set 120 applying the limited output sample $u_{L,n}$ is less than the magnitude of the current drawn by the loudspeaker set 120 of the corresponding input audio sample $r_n$, if it would be applied to the amplifier stage 119. The word "magnitude" used herein to designate the absolute value of the instantaneous amplitude of a time varying signal (e. g. current signal). By convention, the magnitude is always a positive or null value.

The limited audio signal $u_{L,n}$ allows to maintain the magnitude of the drawn current $y_n$ to a maximum value $I_{max}$ until the input audio signal will lead to a lower drawn current again. Because the limited audio signal is also provided to the amplifier stage 119 where it is converted to a voltage driving the loudspeaker set 120, the drawn current by the loudspeaker set is also limited to the maximum value $I_{max}$ inside the sound system or plant 125. Note that the sign of the drawn current $y_n$ may be positive or negative such that the drawn current $y_n$ may be maintained to +/- $I_{max}$.

The threshold decision device 155 receives the predicted current $y_{e,n+1}$ and compares the magnitude (or the absolute value) of it with a threshold $I_{max}$ (i.e. maximum value) to generate a control signal for the selector 160. At each time step n, depending on the control signal generated based on the predicted current $y_{e,n+1}$, the selector 160 delivers $u_n$ as output of the current limiting device 100, wherein $u_n$ is:

- either a limited audio sample $u_{L,n}$ received from the limiting device 140 if the magnitude of the predicted current $y_{e,n+1}$ is higher than the current threshold $I_{max}$;
- or the input audio sample $r_n$ received from the audio source if the magnitude of the predicted current $y_{e,n+1}$ is lower than the threshold $I_{max}$;

When the magnitude of the predicted current $y_{e,n+1}$ is equal to the threshold $I_{max}$, any of the limited audio sample $u_{L,n}$ and the input audio sample $r_n$ may be used.

Based on the above features, the current limiting device 100 is able to predict an increase of the magnitude of the drawn current over a maximum value and to correct the output signal $u_n$ fed to the plant before this maximum value is reached.

The reason why a prediction is used (as opposed to simply using a measured current $m_n$ directly to feed a limiting algorithm) is that the sampling of the drawn current and its transfer to the current limiting device 100 would take time (one or more time steps), and such a delay would limit the ability to react in a timely fashion. Further, a state-space model allows to predict the next samples ahead of time (even when using block processing as described herein), that is at least one sample ahead of the current sample.

Further, with this prediction algorithm, the simpler hardware protection circuit (e.g. a protection circuit that just switches off and restarts the audio power amplifier) may be used and is acceptable, because the current limiting device allows to prevent the trigger of this protection circuit during normal operation.

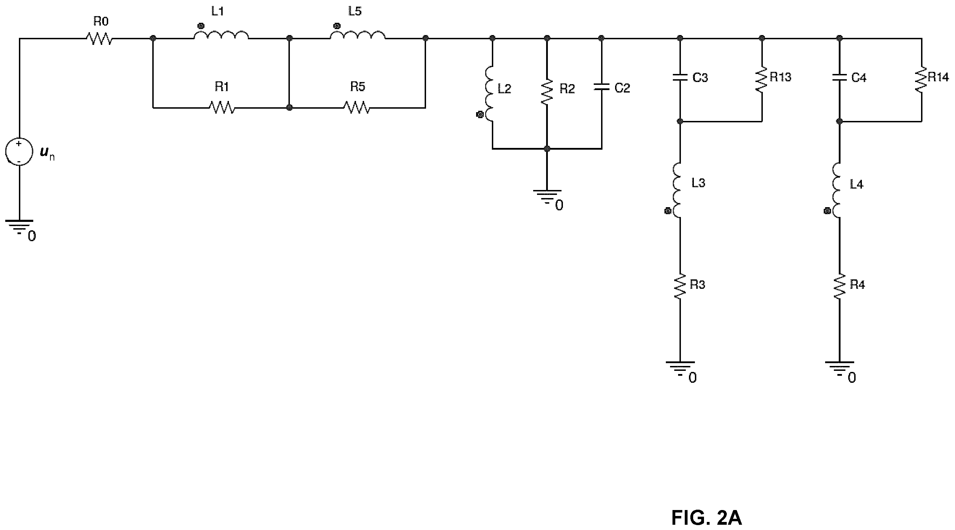

FIG. 2A shows an example of an equivalent electrical circuit for a woofer loudspeaker in a double vented box. In this equivalent electrical circuit, the loudspeaker is driven by a voltage source. For more complex loudspeakers with a cross over network and other drivers, more complex equivalent electrical circuits may be used.

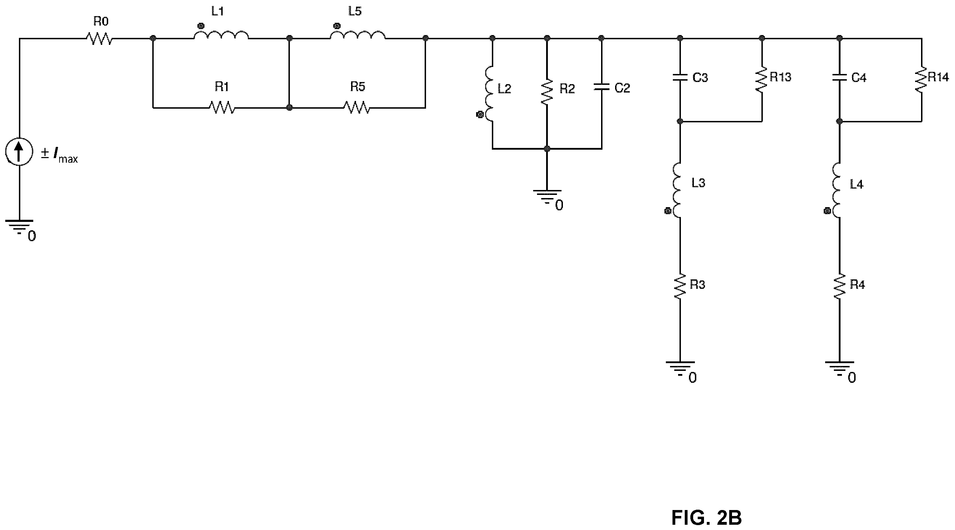

FIG. 2B shows a derived model of an equivalent electrical circuit for a woofer loudspeaker in a double vented box. In this equivalent electrical circuit, the loudspeaker is driven by a current source.

When setting the amplitude of this current source to +/- $I_{max}$ corresponding to the target maximum value for the magnitude of the drawn current $y_n$, the output voltage $u_n$ is obtained at the driving node of the current source. The relationship between the output voltage $u_n$ and the drawn current $y_n$ is given by the loudspeaker set model such that the output voltage $u_n$ allows to obtain the target maximum value for the magnitude of the drawn current can be determined from the loudspeaker set model and the state vector $x_n$ of the loudspeaker set model.

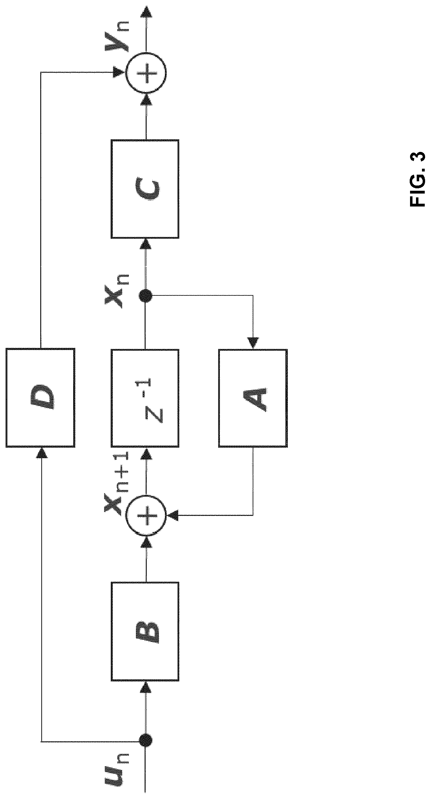

FIG. 3 shows a state-space model that may be used as loudspeaker set model either for a single loudspeaker or a loudspeaker set within a plant. The state vector is denoted $x_n$ and the coefficients of the model are included in matrices and / or vectors A, B, C and D. The size of the state vector $x_n$ and likewise the size of the matrices and / or vectors A, B, C and D may depend on the selected equivalent electrical circuit. The state vector $x_n$ may include all currents of inductors and voltages of capacitors of the equivalent electrical circuit of the loudspeaker set model.

In the example of FIG. 3:

- $u_n$ represents an input sample (e.g. an input voltage); and
- $y_n$ represents an output sample (e.g. a model-based estimated current).

The audio input $r_n$ is copied to device's input $u_n$ unless current limiting occurs. The following computations are performed at each time step:

- Output $y$: $y_n = C \cdot x_n + D \cdot u_n$

- Next state $x$: $x_{n+1} = A \cdot x_n + B \cdot u_n$

- Next input $r$: $r_{e,n+1} = 2 \cdot r_n - r_{n-1}$ (the prediction of $r_{e,n+1}$ is in this example based on a linear extrapolation)

- Next output $y$: $y_{e,n+1} = C \cdot (A \cdot x_n + B \cdot r_n) + D \cdot r_{e,n+1}$

- If $|y_{e,n+1}| > i_{max}$: $y_{e,n+1} = C \cdot (A \cdot x_n + B \cdot u_{L,n}) + D \cdot u_{L,n+1} = \pm i_{max}$

- Smooth transition: $u_{L,n+1} = (1+\lambda) \cdot u_{L,n} - \lambda \cdot u_{n-1}$ ($\lambda$ may be set to 0.5)

- Solution: $u_{L,n} = (C \cdot B + (1+\lambda) \cdot D)^{-1} \cdot (\pm i_{max} - C \cdot A \cdot x_n + \lambda \cdot D \cdot u_{n-1})$

Note that the sign of $\pm i_{max}$ is the same as the sign of $y_{e,n+1}$. The index 'e' indicates that the concerned parameter is an estimate for the next time step n+1.

To improve the accuracy of a loudspeaker set model, a closed-loop controlled model may be used such that a measurement $m_{n-d}$ of the current drawn by the loudspeaker set is available and compared with the current $y_{n-d}$ generated by the loudspeaker set model to generate a feedback error $e_{n-d}$. The feedback error may be obtained after a delay d expressed in number of time steps. This delay may correspond to a number of time steps after which the measured current $m_{n-d}$ is obtained: a corresponding delay line of d time steps is then applied to the current $y_n$ to generate a time-aligned model-based estimated current $y_{n-d}$ and the feedback error $e_{n-d}$. The vector state $x_n$ of the loudspeaker set model is updated based on the feedback error $e_{n-d}$. This closed loop is illustrated in the block diagram of FIG. 1 by the element represented with dotted lines in the current limiting device. The state-space model is thus synchronized with the plant 125 and the loudspeaker set.

The measured current $m_n$ can be obtained for example by a current probe and sampled by an analog-to-digital converter (ADC) (121) and provided to the current limiting device. The prediction algorithm allows to react in a timely fashion to a possible future current. The state-space model allows to predict a next sample ahead of time (one time step ahead of time) and, when this state-space model is used in a closed-loop, the measurement is used to keep the model state variables in sync with the actual loudspeaker set (see FIG. 1).

Back to FIG. 1, the audio system 190 may include

- an audio source 110;
- a current limiting device 100 configured to implement the loudspeaker set model, a prediction algorithm to generate a predicted current for the next time step for a given loudspeaker set based on the loudspeaker set model;
- a sound system 125 (e.g. a plant) including a processing chain with an amplifier (119), followed by a loudspeaker set 120 including one or more loudspeakers;
- a current probe (121) to sample the current at the output of the amplifier;
- analog-to-digital converters (not represented) to convert the input signals $r_n$, $m_n$ into a digital format (if not being already a digital audio signal $r_n$) that can be processed by the current limiting device 100 and a digital-to-analog converter to convert the output signal $u_n$ into an analog format;
- a database (not represented) for storing the pre-calculated coefficients (pre-calculated model matrices) for a list of known loudspeaker sets.

In one or more examples, the loudspeaker set 120 connected to the amplifier (119) may be detected. This could be done automatically at runtime. For that purpose, the audio system 190 may include means for detecting the loudspeaker set connected to the amplifier 119 inside the sound system (125). The means for detecting the loudspeaker set may perform the detection of the loudspeaker set based on a measurement of the impedance of the connected loudspeaker set.

The current limiting device 100 may include means for loading the model coefficients corresponding to the detected loudspeaker set. The equivalent electrical circuit itself may also be selected for the detected loudspeaker set and used to calculate the coefficients of the loudspeaker set model to be implemented by the current limiting device 100. The loading of the model coefficients from the database may be performed when the audio system 190 is switched on or in response to a change of loudspeaker.

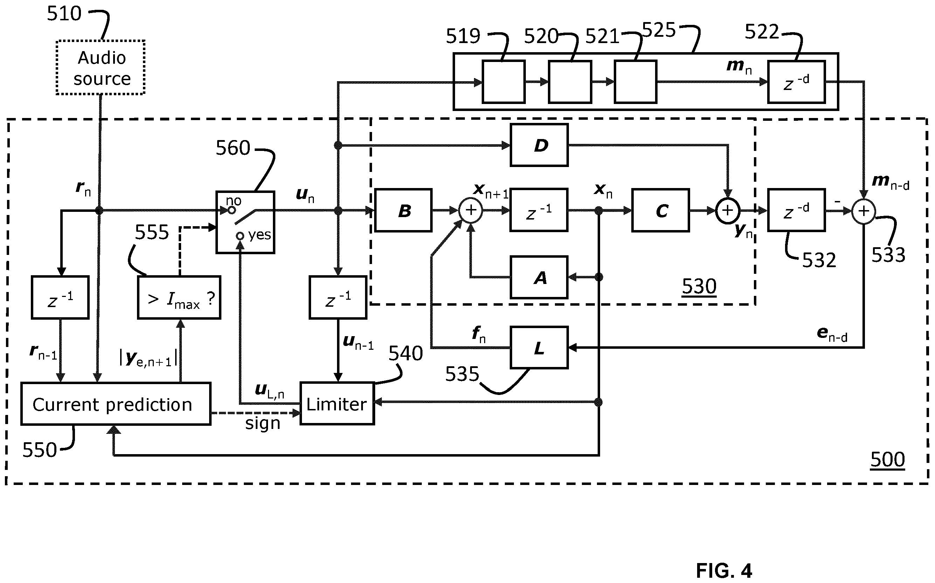

FIG. 4 shows a block diagram of a current limiting device 500 according to an example. FIG. 4 shows how the state-space model of FIG. 3 may be used in a closed-loop with the plant 525 in a current limiting device 500 connected to an audio source 510 and a plant 525.

In the example of FIG. 4, the current limiting device 500 includes devices configured to implement respectively: a loudspeaker set model (modelling device 530), a limiter (limiting device 540), a prediction algorithm (prediction device 550), a selector 560, and a threshold decision (threshold decision device 555). The current limiting device 500 may further include in a feedback loop: a delay element 532, an adder 533 and a state feedback controller 535 whose output is connected to the modelling device 530.

The description made by reference to FIG. 1 applies to the corresponding elements of FIG. 4. Further computation details are provided here for the function of the modelling device 530, the limiting device 540, the prediction device 550 and the threshold decision device 555.

The current limiting device 500 works as follows.

The prediction device 550 receives at least one input audio sample $r_n$ and a state vector $x_n$. The prediction device 550 generates based on the coefficients of the loudspeaker set model an estimated state vector $x_{e,n+1}$ from the input audio sample $r_n$ and a state vector $x_n$:

$$x_{e,n+1} = A \cdot x_n + B \cdot r_n$$

where '.' represents a matrix product.

The prediction device 550 generates an estimated audio sample $r_{e,n+1}$ from one or more input audio samples:

$$r_{e,n+1} = 2 \cdot r_n - r_{n-1}$$

The prediction device 550 generates a predicted current $y_{e,n+1}$ from the estimated state vector $x_{e,n+1}$ and the estimated audio sample $r_{e,n+1}$:

$$y_{e,n+1} = C \cdot x_{e,n+1} + D \cdot r_{e,n+1}$$

The limiting device 540 receives the output audio sample $u_n$ and a state vector $x_n$. The limiting device 540 is configured to generate a limited audio sample $u_{L,n}$ from a current state vector $x_n$ of the loudspeaker set and the sign of the predicted current $y_{e,n+1}$. The limited audio sample $u_{L,n}$ is such that the magnitude of the predicted current is equal to a threshold $I_{max}$:

$$u_{L,n} = M \cdot (I_{max} \cdot \text{sign}\{y_{e,n+1}\} - C \cdot A \cdot x_n + \lambda \cdot D \cdot u_{n-1})$$

The sign function can be defined as:

$$\text{sign}\{x\} = \begin{cases} 1 & if \quad x > 0 \\ -1 & if \quad x < 0 \end{cases}$$

Depending on the hardware and / or software platform, the function sign{0} may return 0 or 1. The herein described method works with both options.

where the matrix $M = (C \cdot B + (1+\lambda) \cdot D)^{-1}$ and A is a scalar such that $0 \le \lambda \le 1$. The scalar A is used to control the control feedback strength and the voltage smoothing on the previous output sample $u_{n-1}$. If $\lambda=0$, the previous input sample $u_{n-1}$ is not taken into account. A good tradeoff between voltage smoothing and control feedback strength is achieved with A = 0.5.

The selector 560 is configured to select either the limited audio sample $u_{L,n}$ or the input audio sample $r_n$ to generate an output sample $u_n$.

The threshold decision device 555 is configured to compare the predicted current $y_{e,n+1}$ with a threshold $I_{max}$

and to control the selector 560 such that the output sample $u_n$ is replaced by the limited audio sample $u_{L,n}$ when the predicted current $y_{e,n+1}$ is higher than the threshold $I_{max}$ (i.e. if $|y_{e,n+1}| > I_{max}$) If the predicted current $y_{e,n+1}$ is lower than the threshold $I_{max}$, the output sample $u_n$ is equal to the input audio sample $r_n$. In case of equality, any of the limited audio sample $u_{L,n}$ and the input audio sample $r_n$ may be used.

The modelling device 530 is configured to update the state vector $x_{n+1}$ and to calculate the current $y_n$ drawn by the loudspeaker set.. The drawn current is calculated as:

$$y_n = C \cdot x_n + D \cdot u_n$$

In the feedback loop, the feedback error may be calculated as:

$$e_{n-d} = m_{n-d} - y_{n-d}$$

where $m_{n-d}$ is the measured current at time step n-d, $y_{n-d}$ is the time-aligned version of the model-based estimated current $y_n$ at time step n-d and d is the measurement delay in time steps.

Finally the state vector is updated for a next time step by taking into account a feedback signal (here, a feedback vector $L \cdot e_{n-d}$) generated by the state feedback controller: the next state vector $x_{n+1}$ may be calculated as:

$$x_{n+1} = A \cdot x_n + B \cdot u_n + L \cdot e_{n-d}$$

The coefficients of the vectors / matrices A, B, C, D, M, L may pre-calculated for each loudspeaker set model. The equivalent electrical circuit shown by FIG. 2B is represented by the matrix M. This matrix M corresponds to an inverse matrix that allows to compute a limited input sample $u_{L,n}$ on the basis of state vector $x_n$, the threshold $I_{max}$, the previous audio sample $u_{n-1}$ and the predicted current $y_{e,n+1}$.

Note that in this implementation, the equivalent electrical circuit of FIG. 2B is used. When setting this current source to $\pm I_{max}$ corresponding to the threshold, the output voltage $u_n$ is obtained at the driving node of the current source. This voltage $u_n$ could then be used as the input voltage to the loudspeaker set model 130 or 530, and also be applied to the plant 125, 525 including the loudspeaker set 120, 520.

The method described above aims to limit the drawn current using a one-time-step look-ahead. Estimating the predicted current $y_{e,n+1}$ and then calculating the output voltage $u_n$ reduces abrupt voltage changes and unwanted high frequency content.

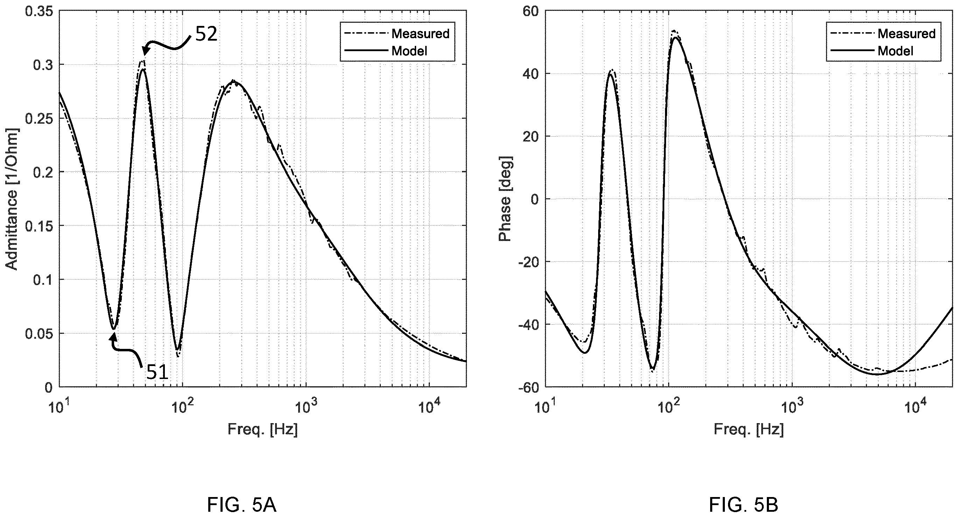

FIG. 5 shows curves representing the variations over frequency of the magnitude (FIG. 5A) and phase (FIG. 5B) of the admittance for a typical loudspeaker set according to an example. Each dotted line curve corresponds to a curve obtained respectively based on current and voltage measurements and each plain line curve corresponds to a curve obtained based respectively on current and voltage values generated by the model of the loudspeaker set. A minimum 51 of the curves appears at 28 Hz, that corresponds to a situation with a low admittance and for which a low current is expected when a voltage is applied. A maximum peak 52 of the curves appears at 47 Hz, that corresponds to a situation with a high admittance and for which a high current is expected when a voltage is applied. By comparing in each figure the dotted line curve with the plain line curve, it appears that both the phase and magnitude of the admittance are matched accurately by the model.

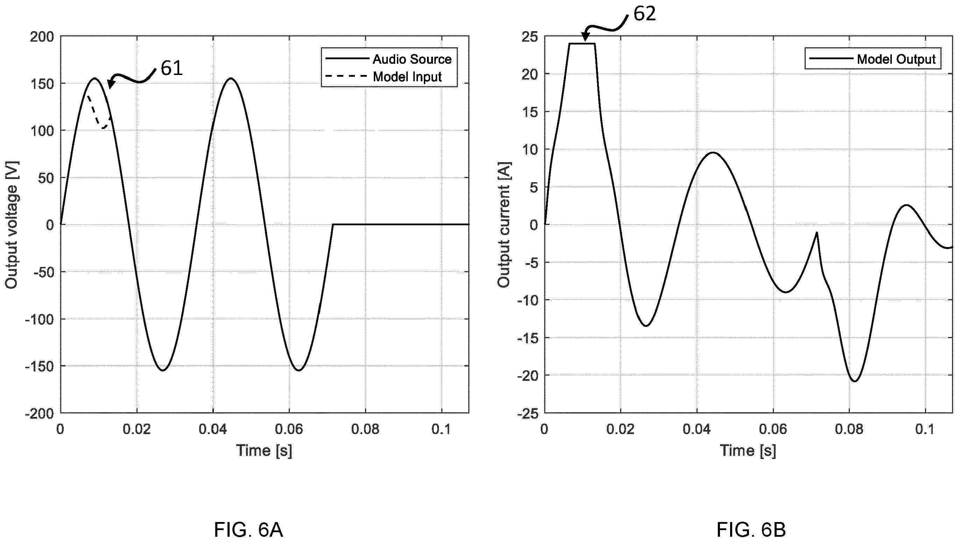

FIG. 6 shows a burst signal with sine waves at 28 Hz. In FIG. 6A, the input voltage corresponding to input samples ($r_n$) from the audio source is represented by a plain line, while the limited output voltage ($u_{L,n}$) is represented by a dotted line: this limited output voltage is generated by the limiter device 140, 540 to replace the input voltage and generate the voltage ($u_n$) fed to the plant, which is also the voltage at the input of the loudspeaker set model 130. FIG. 6B represents the output current ($y_n$) at the output of the loudspeaker set model 130, 530. FIG. 6B shows the effects of the current limiting applied by the current limiting device. By replacing the input voltage by the limited output voltage during the first peak 61 in FIG. 6A, the output current is limited, clipped to $I_{max}$ = 24 A during the same period of time as shown by the peak 62 in FIG. 6B. As the signal is at 28 Hz, although we are in a situation in which the admittance is low and a low current is expected, we are in transient conditions and observe that a current limitation is needed and a clipping occurs.

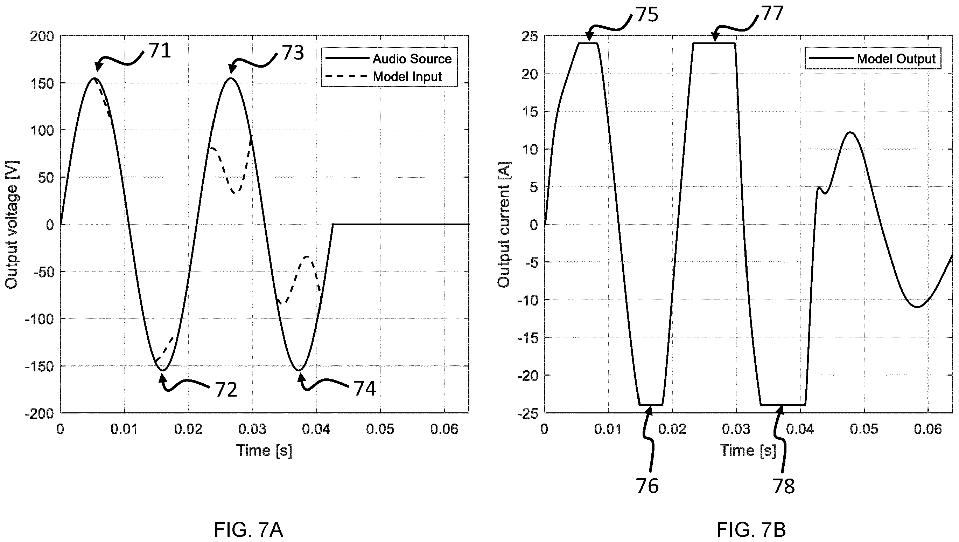

FIG. 7 shows the same curves than in FIG. 6 but with sine waves at 47 Hz at which the admittance is high and a high current is expected. But here during switch on (transient conditions), we observe that for the first voltage peaks 71, 72 almost no voltage limitation occurs but during the corresponding current peaks 75, 76 a clipping to $I_{max}$ = 24 A occurs. For the next voltage peaks 73, 74 a strong voltage limitation occurs and a clipping to $I_{max}$ = 24 A also occurs for corresponding current peaks 77, 78.

It should be appreciated by those skilled in the art that any functions, engines, block diagrams, flow diagrams, state transition diagrams, flowchart and / or data structures described herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processing apparatus, whether or not such computer or processor is explicitly shown.

Although a flow chart may describe operations as a sequential process, many of the operations may be performed in parallel, concurrently, or simultaneously. Also, some operations may be omitted, combined, or performed in different order. A process may be terminated when its operations are completed but may also have additional steps not disclosed in the figure or description. A process may correspond to a method, function, procedure, subroutine, subprogram, etc. When a process corresponds to a function, its termination may correspond to a return of the function to the calling function or the main function.

Each described function, engine, block, step described herein can be implemented in hardware, software, firmware, middleware, microcode, or any suitable combination thereof.

In the present description, the wording "means for performing a function" or "means configured to perform a function" may correspond to one or more functional blocks comprising circuitry that is adapted for performing or configured to perform this function. The block may perform itself this function or may cooperate and / or communicate with other one or more blocks to perform this function. The "means" may correspond to or be implemented as "one or more modules", "one or more devices", "one or more units", etc. The means may include at least one processor, at least one memory storing instructions configured to cause a target device / system to perform the concerned function.

The current limiting device may be implemented by software and / or hardware.

When implemented in software, the current limiting device may be implemented by circuitry (e.g., one or more circuits). Several types of circuitries may be used: digital signal processor (DSP) hardware, processor or microprocessor, application specific integrated circuit (ASIC), field programmable gate array (FPGA), etc. The circuitry may be or include, for example, hardware, programmable logic, a programmable processor that executes software or firmware, and / or any combination thereof (e.g., a processor, control unit / entity, controller) to execute instructions or software and control transmission and receptions of signals, and a memory to store data and / or instructions.

When implemented in software, firmware, middleware or microcode, instructions to perform the necessary tasks may be stored in a computer readable medium that may be or not included in a target device or system. The instructions may be transmitted over the computer-readable medium and be loaded onto the target device or system. The instructions are configured to cause the target device / system to perform one or more functions disclosed herein. For example, as mentioned above, according to one or more examples, at least one memory may include or store instructions, the at least one memory and the instructions may be configured to, with at least one processor, cause the target device / system to perform the one or more functions. Additionally, the processor, memory, and instructions, serve as means for providing or causing performance by the target device / system of one or more functions disclosed herein.

The instructions may correspond to computer program instructions, computer program code and may include one or more code segments. A code segment may represent a procedure, function, subprogram, program, routine, subroutine, module, software package, class, or any combination of instructions, data structures or program statements.

When provided by a processor, the functions may be provided by a single dedicated processor, by a single shared processor, or by a plurality of individual processors, some of which may be shared. The term "processor" should not be construed to refer exclusively to hardware capable of executing software and may implicitly include one or more processing circuits, whether programmable or not. A processing circuit may correspond to a digital signal processor (DSP), a network processor, an application specific integrated circuit (ASIC), a field programmable gate array (FPGA), a System-on-Chips (SoC), a Central Processing Unit (CPU), a Processing Unit (CPU), an arithmetic logic unit (ALU), a programmable logic unit (PLU), a processing core, a programmable logic, a microprocessor, a controller, a microcontroller, a microcomputer, any device capable of responding to and / or executing instructions in a defined manner and / or according to a defined logic. Other hardware, conventional or custom, may also be included. A processor may be configured to execute instructions adapted for causing the performance by a target device or system of one or more functions disclosed herein for the concerned device or system.

A computer readable medium or computer readable storage medium may be any storage medium suitable for storing instructions readable by a computer or a processor. A computer readable medium may be more generally any storage medium capable of storing and / or containing and / or carrying instructions and / or data. A computer-readable medium may be a portable or fixed storage medium. A computer readable medium may include one or more storage device like a permanent mass storage device, magnetic storage medium, optical storage medium, digital storage disc (CD-ROM, DVD, Blue Ray, etc.), USB key or dongle or peripheral, memory card, random access memory (RAM), read only memory (ROM), core memory, flash memory, or any other non-volatile storage.

A memory suitable for storing instructions may be a random-access memory (RAM), read only memory (ROM), and / or a permanent mass storage device, such as a disk drive, memory card, random access memory (RAM), read only memory (ROM), core memory, flash memory, or any other non-volatile storage.

Although the terms first, second, etc. may be used herein to describe various elements, these elements should not be limited by these terms. These terms are only used to distinguish one element from another. For example, a first element could be termed a second element, and similarly, a second element could be termed a first element, without departing from the scope of this disclosure. As used herein, the term "and / or," includes any and all combinations of one or more of the associated listed items.

When an element is referred to as being "connected" or "coupled" to another element, it can be directly connected or coupled to the other element or intervening elements may be present. By contrast, when an element is referred to as being "directly connected" or "directly coupled" to another element, there are no intervening elements present. Other words used to describe the relationship between elements should be interpreted in a like fashion (e.g., "between," versus "directly between," "adjacent," versus "directly adjacent," etc.).

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and / or "including," when used herein, specify the presence of stated features, integers, steps, operations, elements, and / or components, but do not preclude the presence or addition of one or more other features, integers, steps, operations, elements, components, and / or groups thereof.

Specific details are provided in the following description to provide a thorough understanding of some examples. However, it will be understood by one of ordinary skill in the art that example embodiments may be practiced without these specific details disclosed for illustrative purposes. For example, systems may be shown in block diagrams so as not to obscure the examples in unnecessary detail. In other instances, well-known processes, structures, and techniques may be shown without unnecessary detail in order to avoid obscuring the examples.

Benefits, other advantages, and solutions to problems have been described above with regard to specific embodiments of the invention. However, the benefits, advantages, solutions to problems, and any element(s) that may cause or result in such benefits, advantages, or solutions, or cause such benefits, advantages, or solutions to become more pronounced are not to be construed as a critical, required, or essential feature or element of the invention.

**Claims**

1. A device (100, 500) for use with a plant (125, 525) including a loudspeaker set, wherein the device is configured to receive input audio samples ($r_n$) and a measured current ($m_{n-d}$) drawn by the loudspeaker set, the device comprising:

   - a modelling device (130, 530) configured to generate, for a current time step, using a state-space model of the loudspeaker set, a state vector ($x_n$) and a model-based estimated current ($y_n$);
   - a prediction device (150, 550) configured to generate, based on the state vector ($x_n$), a predicted current ($y_{e,n+1}$) for a next time step;
   - a limiting device (140, 540) configured to generate, for the current time step, a limited audio sample ($u_{L,n}$) based on the state vector ($x_n$);
   - a state feedback controller (135, 235) configured to generate a feedback signal ($f_n$) that contributes to the generation of the state vector ($x_{n+1}$) for the next time step and is based on the measured current ($m_{n-d}$) and a time-aligned model-based estimated current ($y_{n-d}$); wherein the device is configured to generate an output audio sample ($u_n$) for the current time step, wherein the output audio sample ($u_n$) is either the input audio sample ($r_n$) for the current time step or the limited audio sample ($u_{L,n}$) when the predicted current ($y_{e,n+1}$) is higher in magnitude than a threshold ($I_{max}$).

2. The device (100, 500) according to claim 1, wherein the prediction device (150, 550) is configured to generate the predicted current ($y_{e,n+1}$) based on one or more input audio samples ($r_n$; $r_{n-1}$).

3. The device (100, 500) according to claim 1 or 2, wherein the prediction device (150, 550) is configured to generate the predicted current ($y_{e,n+1}$) based on an estimated audio sample ($r_{e,n+1}$) for the next time step or the input audio sample ($r_{n+1}$) for the next time step .

4. The device (100, 500) according to any of the preceding claims, wherein the limiting device (140, 540) is configured to generate the limited audio sample ($u_{L,n}$) based on a model derived from the state-space model (130, 530).

5. The device (100, 500) according to any of the preceding claims, wherein the limiting device (140, 540) is configured to generate the limited audio sample ($u_{L,n}$) based on the threshold representing a maximum current.

6. The device (100, 500) according to any of the preceding claims, wherein the limited audio sample $u_{L,n}$ is generated such that the magnitude of the predicted current ($y_{e,n+1}$) is equal to the threshold ($I_{max}$).

7. The device (100, 500) according to any of the preceding claims, wherein the limited audio sample $u_{L,n}$ is generated based on the sign of the predicted current ($y_{e,n+1}$).

8. The device (100, 500) according to any of the preceding claims, wherein the limited audio sample $u_{L,n}$ is generated based on an output sample $u_{n-1}$ for a previous time step.

9. A method for use with a plant (125, 525) including a loudspeaker set (120, 520), the method comprising

   - obtaining input audio samples ($r_n$) and a measured current ($m_{n-d}$) drawn by the loudspeaker set;
   - generating, for a current time step, using a state-space model of the loudspeaker set, a state vector ($x_n$) and a model-based estimated current ($y_n$);
   - generating, based on the state vector ($x_n$), a predicted current ($y_{e,n+1}$) for a next time step;
   - generating, for the current time step, a limited audio sample ($u_{L,n}$) based on the state vector ($x_n$);
   - generating a feedback signal ($f_n$) that contributes to the generation of the state vector ($x_{n+1}$) for the next time step and is based on the measured current ($m_{n-d}$) and a time-aligned model-based estimated current ($y_{n-d}$);
   - generating an output audio sample ($u_n$) for the current time step, wherein the output audio sample ($u_n$) is either the input audio sample ($r_n$) for the current time step or the limited audio sample ($u_{L,n}$) when the predicted current ($y_{e,n+1}$) is higher in magnitude than a threshold ($I_{max}$).

10. A computer program comprising computer-executable instructions that, when executed by at least one processor, causes a device to perform a method as claimed in claim 9.

11. A device for use with a plant (125, 525) including a loudspeaker set (120, 520), the device comprising signal processing means for performing a method comprising:

    - obtaining input audio samples ($r_n$) and a measured current ($m_{n-d}$) drawn by the loudspeaker set;
    - generating, for a current time step, using a state-space model of the loudspeaker set, a state vector ($x_n$) and a model-based estimated current ($y_n$);
    - generating, based on the state vector ($x_n$), a predicted current ($y_{e,n+1}$) for a next time step;
    - generating, for the current time step, a limited audio sample ($u_{L,n}$) based on the state vector ($x_n$);
    - generating a feedback signal ($f_n$) that contributes to the generation of the state vector ($x_{n+1}$) for the next time step and is based on the measured current ($m_{n-d}$) and a time-aligned model-based estimated current ($y_{n-d}$);
    - generating an output audio sample ($u_n$) for the current time step, wherein the output audio sample ($u_n$) is either the input audio sample ($r_n$) for the current time step or the limited audio sample ($u_{L,n}$) when the predicted current ($y_{e,n+1}$) is higher in magnitude than a threshold ($I_{max}$).

12. The device according to claim 11, wherein the signal processing means comprises at least one processor and at least one memory including computer program instructions, wherein the at least one memory and the computer program instructions are configured to, with the at least one processor, cause the device to perform at least one step of the method.

13. The device according to claim 11 or 12, wherein the signal processing means comprises circuitry configured to cause the device to perform at least one step of the method.

14. The device according to any of claims 10 to 13, wherein the signal processing means comprises a digital signal processor configured to cause the device to perform at least one step of the method.

15. A system (190) including a device (100) according to any of claims 1 to 8 or 11 to 14, the system comprising a database configured to store model coefficients of state-space models for several loudspeaker sets and means for loading the model coefficients corresponding to the loudspeaker set.

**Amended claims in accordance with Rule 137(2) EPC.**

1. A device (100, 500) for use with a plant (125, 525) including a loudspeaker set, wherein the device is configured to receive input audio samples ($r_n$) and a measured current ($m_{n-d}$) drawn by the loudspeaker set and to generate an output audio sample ($u_n$) for a current time step, the device comprising:

- a modelling device (130, 530) configured to generate, for the current time step, using a state-space model of the loudspeaker set and from the output audio sample ($u_n$), a state vector ($x_n$) and a model-based estimated current ($y_n$) of the current drawn by the loudspeaker set;
- a prediction device (150, 550) configured to generate, based on the state vector ($x_n$), a predicted current ($y_{e,n+1}$) for a next time step;
- a limiting device (140, 540) configured to generate, for the current time step, a replacement audio sample ($u_{L,n}$) based on the state vector ($x_n$), wherein the replacement audio sample is such that the magnitude of the current drawn by the loudspeaker set is limited to a maximum value;
- a state feedback controller (135, 235) configured to generate a feedback signal ($f_n$) that is fed to the state-space model to contribute to the generation of the state vector ($x_{n+1}$) for the next time step, wherein the feedback signal ($f_n$) is based on a comparison between the measured current ($m_{n-d}$) and a time-aligned model-based estimated current ($y_{n-d}$);

wherein the output audio sample ($u_n$) is either the input audio sample ($r_n$) for the current time step or the replacement audio sample ($u_{L,n}$) when the predicted current ($y_{e,n+1}$) is higher in magnitude than a threshold ($I_{max}$).

2. The device (100, 500) according to claim 1, wherein the prediction device (150, 550) is configured to generate the predicted current ($y_{e,n+1}$) based on one or more input audio samples ($r_n$; $r_{n-1}$).

3. The device (100, 500) according to claim 1 or 2, wherein the prediction device (150, 550) is configured to generate the predicted current ($y_{e,n+1}$) based on an estimated audio sample ($r_{e,n+1}$) for the next time step or the input audio sample ($r_{n+1}$) for the next time step.

4. The device (100, 500) according to any of the preceding claims, wherein the limiting device (140, 540) is configured to generate the replacement audio sample ($u_{L,n}$) based on a model derived from the state-space model (130, 530).

5. The device (100, 500) according to any of the preceding claims, wherein the limiting device (140, 540) is configured to generate the replacement audio sample ($u_{L,n}$) based on the threshold representing a maximum current.

6. The device (100, 500) according to any of the preceding claims, wherein the replacement audio sample $u_{L,n}$ is generated such that the magnitude of the predicted current ($y_{e,n+1}$) is equal to the threshold ($I_{max}$).

7. The device (100, 500) according to any of the preceding claims, wherein the replacement audio sample $u_{L,n}$ is generated based on the sign of the predicted current ($y_{e,n+1}$).

8. The device (100, 500) according to any of the preceding claims, wherein the replacement audio sample $u_{L,n}$ is generated based on an output sample $u_{n-1}$ for a previous time step.

9. A method for use with a plant (125, 525) including a loudspeaker set (120, 520), the method comprising

- obtaining input audio samples ($r_n$) and a measured current ($m_{n-d}$) drawn by the loudspeaker set;
- generating an output audio sample ($u_n$) for a current time step;
- generating, for the current time step, using a state-space model of the loudspeaker set and from the output audio sample ($u_n$), a state vector ($x_n$) and a model-based estimated current ($y_n$) of the current drawn by the loudspeaker set;
- generating, based on the state vector ($x_n$), a predicted current ($y_{e,n+1}$) for a next time step;
- generating, for the current time step, a replacement audio sample ($u_{L,n}$) based on the state vector ($x_n$), wherein the replacement audio sample is such that the magnitude of the current drawn by the loudspeaker set is limited to a maximum value;
- generating a feedback signal ($f_n$) that is fed to the state-space model to contribute to the generation of the state vector ($x_{n+1}$) for the next time step, wherein the feedback signal ($f_n$) is based on a comparison between the measured current ($m_{n-d}$) and a time-aligned model-based estimated current ($y_{n-d}$);

wherein the output audio sample ($u_n$) is either the input audio sample ($r_n$) for the current time step or the replacement audio sample ($u_{L,n}$) when the predicted current ($y_{e,n+1}$) is higher in magnitude than a threshold ($I_{max}$).

**10.** A computer program comprising computer-executable instructions that, when executed by at least one processor, causes a device to perform a method as claimed in claim 9.

**11.** A device for use with a plant (125, 525) including a loudspeaker set (120, 520), the device comprising signal processing means for performing a method comprising:

- obtaining input audio samples ($r_n$) and a measured current ($m_{n-d}$) drawn by the loudspeaker set;
- generating an output audio sample ($u_n$) for a current time step;
- generating, for the current time step, using a state-space model of the loudspeaker set and from the output audio sample ($u_n$), a state vector ($x_n$) and a model-based estimated current ($y_n$) of the current drawn by the loudspeaker set;
- generating, based on the state vector ($x_n$), a predicted current ($y_{e,n+1}$) for a next time step;
- generating, for the current time step, a replacement audio sample ($u_{L,n}$) based on the state vector ($x_n$), wherein the replacement audio sample is such that the magnitude of the current drawn by the loudspeaker set is limited to a maximum value;
- generating a feedback signal ($f_n$) that is fed to the state-space model to contribute to the generation of the state vector ($x_{n+1}$) for the next time step, wherein the feedback signal ($f_n$) is based on a comparison between the measured current ($m_{n-d}$) and a time-aligned model-based estimated current ($y_{n-d}$);

wherein the output audio sample ($u_n$) is either the input audio sample ($r_n$) for the current time step or the replacement audio sample ($u_{L,n}$) when the predicted current ($y_{e,n+1}$) is higher in magnitude than a threshold ($I_{max}$).

**12.** The device according to claim 11, wherein the signal processing means comprises at least one processor and at least one memory including computer program instructions, wherein the at least one memory and the computer program instructions are configured to, with the at least one processor, cause the device to perform at least one step of the method.

**13.** The device according to claim 11 or 12, wherein the signal processing means comprises circuitry configured to cause the device to perform at least one step of the method.

**14.** The device according to any of claims 10 to 13, wherein the signal processing means comprises a digital signal processor configured to cause the device to perform at least one step of the method.

**15.** A system (190) including a device (100) according to any of claims 1 to 8 or 11 to 14, the system comprising a database configured to store model coefficients of state-space models for several loudspeaker sets and means for loading the model coefficients corresponding to the loudspeaker set.

FIG. 1

FIG. 2A

FIG. 2B

EP 4 293 901 A1

FIG. 3

FIG. 4

FIG. 5A

FIG. 5B

FIG. 6B

FIG. 6A

FIG. 7B

FIG. 7A

Europäisches
Patentamt

European
Patent Office

Office européen
des brevets

# EUROPEAN SEARCH REPORT

**Application Number**

EP 22 30 5871

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARCO BERKHOUT ET AL: "A 4 2.3W class-D audio amplifier with embedded DC-DC boost converter, current-sensing ADC and DSP for adaptive speaker protection", SOLID-STATE CIRCUITS CONFERENCE DIGEST OF TECHNICAL PAPERS (ISSCC), 2013 IEEE INTERNATIONAL, IEEE, 17 February 2013 (2013-02-17), pages 180-181, XP032350527, DOI: 10.1109/ISSCC.2013.6487690 ISBN: 978-1-4673-4515-6 * figures 10.5.1-10.5.6 * * page 180, left-hand column, line 1 - right-hand column, line 45 * ----- | 1-15 | INV. H03F1/52 H03F3/187 |
| X | US 2015/229353 A1 (BERTHELSEN KIM SPETZLER [DK] ET AL) 13 August 2015 (2015-08-13) * figures 1-4 * * paragraphs [0001] - [0080] * ----- | 1-15 | |
| X | US 9 900 690 B2 (CIRRUS LOGIC INT SEMICONDUCTOR LTD [GB]) 20 February 2018 (2018-02-20) * figures 1-28 * * column 1, line 1 - column 61, line 58 * ----- | 1-15 | TECHNICAL FIELDS SEARCHED (IPC) H03F |

The present search report has been drawn up for all claims

| Place of search | Date of completion of the search | Examiner |
|---|---|---|
| The Hague | 25 November 2022 | Jespers, Michaël |

EPO FORM 1503 03.82 (P04C01)

**EP 4 293 901 A1**

## ANNEX TO THE EUROPEAN SEARCH REPORT
## ON EUROPEAN PATENT APPLICATION NO.

EP 22 30 5871

25-11-2022

| Patent document cited in search report | | Publication date | Patent family member(s) | | Publication date |
|---|---|---|---|---|---|
| US 2015229353 | A1 | 13-08-2015 | CN | 104837092 A | 12-08-2015 |
| | | | DE | 102015101729 A1 | 13-08-2015 |
| | | | KR | 20150099417 A | 31-08-2015 |
| | | | US | 2015229353 A1 | 13-08-2015 |
| US 9900690 | B2 | 20-02-2018 | CN | 105103568 A | 25-11-2015 |
| | | | EP | 2901711 A2 | 05-08-2015 |
| | | | US | 2015304772 A1 | 22-10-2015 |
| | | | US | 2017318388 A1 | 02-11-2017 |
| | | | WO | 2014045123 A2 | 27-03-2014 |

EPO FORM P0459

For more details about this annex : see Official Journal of the European Patent Office, No. 12/82